# EUROPEAN PATENT APPLICATION

(11) **EP 4 757 528 A1**
(43) Date of publication of application: **10.06.2026**
(21) Application number: 24223467.2
(22) Date of filing: 27.12.2024
(51) Int. Cl.: H10D 30/47, H10D 30/01, H10D 64/00, H10D 62/13, H10D 62/85

(54) **HEMT DEVICE AND METHOD OF FABRICATING THE SAME**

(30) Priority: 06.12.2024 CN 202411793333
(71) Applicant: Schneider Electric (China) Co., Ltd., Beijing 100102 (CN)
(72) Inventor: CHEN, Jiamin, 201203 Shangai (CN)
(74) Representative: Manitz Finsterwald Patent- und Rechtsanwaltspartnerschaft mbB

(57) **Abstract**

Provided is a HEMT device and a method of fabricating the same. The HEMT device includes: a substrate (11); a buffer layer (12) disposed on the substrate; a channel layer (13) disposed on the buffer layer; a barrier layer (14) disposed on the channel layer; a first electrode (151) and a second electrode (152) coupled to opposite sides of the barrier layer; a first gate (161) disposed on the barrier layer adjacent to the first electrode and surrounded by the passivation layer (17), and a second gate (162) disposed on the barrier layer adjacent to the second electrode and surrounded by the passivation layer; and one or more floating field plates (18) disposed between the first gate and the second gate and spaced apart from the barrier layer, the one or more floating field plates being surrounded by the passivation layer.

## Description

### FIELD

Embodiments of the present disclosure generally relate to a semiconductor device, and more particularly, to a high electron mobility transistor (HEMT) device, a method of fabricating a HEMT device, and a solid-state circuit breaker including a HEMT device.

### BACKGROUND

A solid-state circuit breaker is a circuit breaker using a power semiconductor device as a main switch. Since the relative position of the solid-state circuit breaker with respect to a bus and a load is not fixed, the solid-state circuit breaker needs to be capable of achieving a turn-off function in both directions. A conventional solution is to connect the sources of a pair of power semiconductor devices to each other so as to be connected in series. However, such an arrangement will result in an increased on-resistance and cost of the device, and a corresponding heat dissipation difficulty will also be increased. In addition, when a short circuit fault occurs, the current flowing through the solid-state circuit breaker gradually increases over time, and the device needs a certain time to be turned off, which results in the risk faced after the short circuit occurs being related to the time needed for the device to be turned off.

### SUMMARY

An object of the present disclosure is to provide a HEMT device, a method of fabricating a HEMT device, and a solid-state circuit breaker including a HEMT device to at least partially solve the above described problems and other potential problems.

In a first aspect of the present disclosure, a HEMT device is provided. The HEMT device includes: a substrate; a buffer layer disposed on the substrate; a channel layer disposed on the buffer layer; a barrier layer disposed on the channel layer; a first electrode and a second electrode coupled to opposite sides of the barrier layer; a first gate disposed on the barrier layer adjacent to the first electrode and surrounded by a passivation layer, and a second gate disposed on the barrier layer adjacent to the second electrode and surrounded by the passivation layer; and one or more floating field plates disposed between the first gate and the second gate and spaced apart from the barrier layer, the one or more floating field plates being surrounded by the passivation layer.

In some embodiments, a first turn-off voltage is applied to the first gate in a case that a short circuit current flows from the second electrode to the first electrode, and a second turn-off voltage is applied to the second gate in a case that a short circuit current flows from the first electrode to the second electrode.

In some embodiments, in a case that a short circuit current flows from the second electrode to the first electrode, a corresponding adjusting voltage is applied to at least one of the one or more floating field plates and the second gate , and in a case that a short circuit current flows from the first electrode to the second electrode, a corresponding adjusting voltage is applied to at least one of the one or more floating field plates and the first gate.

In some embodiments, in a case that a short circuit current flows from the second electrode to the first electrode, a corresponding adjusting voltage is applied to each of the one or more floating field plates and the second gate, and voltages of the second gate, the one or more floating field plates, and the first gate are gradually decreased in a direction from the second electrode to the first electrode; and in a case that a short circuit current flows from the first electrode to the second electrode, a corresponding adjusting voltage is applied to each of the one or more floating field plates and the first gate, and voltages of the first gate, the one or more floating field plates, and the second gate are gradually decreased in a direction from the first electrode to the second electrode.

In some embodiments, in a case that a short circuit current flows from the second electrode to the first electrode, voltages are sequentially applied to the first gate, the one or more floating field plates, and the second gate in a direction from the first electrode to the second electrode; and in a case that a short circuit current flows from the first electrode to the second electrode, voltages are sequentially applied to the second gate, the one or more floating field plates, and the first gate in a direction from the second electrode to the first electrode.

In some embodiments, when the HEMT device is to be turned on and a voltage of the second electrode is higher than a voltage of the first electrode, a first turn-on voltage is applied to the first gate, and when the HEMT device is to be turned on and a voltage of the first electrode is higher than a voltage of the second electrode, a second turn-on voltage is applied to the second gate.

In some embodiments, when the HEMT device is to be turned on and the voltage of the second electrode is higher than the voltage of the first electrode, a corresponding adjusting voltage is applied to at least one of the one or more floating field plates and the second gate, and when the HEMT device is to be turned on and the voltage of the first electrode is higher than the voltage of the second electrode, a corresponding adjusting voltage is applied to at least one of the one or more floating field plates and the first gate.

In some embodiments, when the HEMT device is to be turned on and the voltage of the second electrode is higher than the voltage of the first electrode, voltages are sequentially applied to the first gate, the one or more floating field plates, and the second gate in a direction from the first electrode to the second electrode; and when the HEMT device is to be turned on and the voltage of the first electrode is higher than the voltage of the second electrode, voltages are sequentially applied to the second gate, the one or more floating field plates, and the first gate in the direction from the second electrode to the first electrode.

In some embodiments, the one or more floating field plates include a first floating field plate adjacent to the first gate and a second floating field plate adjacent to the second gate.

In some embodiments, the first electrode, the first gate, the first floating field plate, the second floating field plate, the second gate, and the second electrode are disposed at equal intervals.

In some embodiments, the HEMT device further includes: a first voltage regulator diode coupled between the first electrode and the first gate; a second voltage regulator diode coupled between the second electrode and the second gate; a third voltage regulator diode coupled between the first electrode and the first floating field plate; and a fourth voltage regulator diode coupled between the second electrode and the second floating field plate.

In a second aspect of the present disclosure, a method of fabricating a HEMT device is provided, the method including: providing a substrate; forming a buffer layer on the substrate; forming a channel layer on the buffer layer; forming a barrier layer on the channel layer; forming a first electrode and a second electrode coupled to opposite sides of the barrier layer; forming a first passivation layer on the barrier layer; etching the first passivation layer to form a first through hole and a second through hole in the first passivation layer, the first through hole being adj acent to the first electrode, the second through hole being adj acent to the second electrode, each of the first through hole and the second through hole extending from a first side of the first passivation layer facing away from the barrier layer to a second side of the first passivation layer facing towards the barrier layer; depositing a conductive material in the first through hole and the second through hole to form a first gate in the first through hole and to form a second gate in the second through hole; etching the first passivation layer to form one or more grooves in the first passivation layer, the one or more grooves extending from the first side of the first passivation layer to a predetermined depth within the first passivation layer; depositing a conductive material in the one or more grooves to form one or more floating field plates in the one or more grooves; and forming a second passivation layer on the first passivation layer to cover the first gate, the second gate, and the one or more floating field plates.

In some embodiments, the one or more floating field plates include a first floating field plate adjacent to the first gate and a second floating field plate adjacent to the second gate.

In some embodiments, the method further including: forming a first voltage regulator diode coupled between the first electrode and the first gate; forming a second voltage regulator diode coupled between the second electrode and the second gate; forming a third voltage regulator diode coupled between the first electrode and the first floating field plate; and forming a fourth voltage regulator diode coupled between the second electrode and the second floating field plate.

In a third aspect of the present disclosure, a solid-state circuit breaker is provided, the solid-state circuit breaker including the HEMT device of the first aspect of the present disclosure.

In the embodiments of the present disclosure, by providing two gates in a HEMT device and providing a floating field plate between the two gates, the HEMT device is enabled to achieve a bidirectional turn-off function, and is suitable for use in a solid-state circuit breaker. In this way, bidirectional turn-off can be achieved only by using a single die without connecting sources of a pair of power semiconductor devices to each other so as to be connected in series, thereby significantly reducing an on-resistance and cost of the device. In addition, the turn-off speed of the HEMT device according to the embodiments of the present disclosure is faster, and the current loop can be quickly cut off after a short circuit occurs, thereby avoiding damage to a bus, a load and the HEMT device itself.

It should be understood that the content described in this content section is not intended to limit key features or essential features of embodiments of the present disclosure, nor is it intended to limit the scope of the present disclosure. Other features of the present disclosure will become readily understood from the following description.

### BRIEF DESCRIPTION OF THE DRAWINGS

The above and other features, advantages, and aspects of various embodiments of the present disclosure will become more apparent with reference to the following detailed description taken in conjunction with the accompanying drawings. In the drawings, the same or similar reference signs refer to the same or similar elements, wherein:
Fig. 1 shows a schematic structural view of a switch unit in a conventional solid-state circuit breaker;
Fig. 2 shows a schematic structural view of a HEMT device according to some embodiments of the present disclosure;
Figs. 3-5 show schematic structural views of HEMT devices according to other embodiments of the present disclosure; and
Figs. 6A-6L show example processes of fabricating a HEMT device according to some embodiments of the present disclosure.

### Description of Reference Numerals:

101 first HEMT device; 102 second HEMT device; 100 HEMT device; 11 substrate; 12 buffer layer; 13 channel layer; 14 barrier layer;151 first electrode; 152 second electrode; 161 first gate; 162 second gate; 17 passivation layer; 1701 first passivation layer; 1702 second passivation layer; 171 first through hole; 172 second through hole; 173 groove; 18 floating field plates; 181 first floating field plate;182 second floating field plate; 183 third floating field plate; 191 first voltage regulator diode; 192 second voltage regulator diode;193 third voltage regulator diode; 194 fourth voltage regulator diode.

### DETAILED DESCRIPTION

Embodiments of the present disclosure will be described in more detail below with reference to the accompanying drawings. Although the embodiments of the present disclosure are shown in the accompanying drawings, it should be understood that the present disclosure may be achieved in various forms and should not be limited to the embodiments set forth herein. Rather, these embodiments are provided to make the present disclosure more thorough and complete, and to fully convey the scope of the present disclosure to those skilled in the art.

As used herein, the term "including" and variations thereof mean open-ended including, that is, "including but not limited to". Unless specifically stated, the term "or" means "and/or". The term "based on" means "based at least in part on". The terms "an example embodiment" and "an embodiment" mean "at least one example embodiment". The term "another embodiment" means "at least one further embodiment". The terms "first", "second" and the like may refer to different or identical objects.

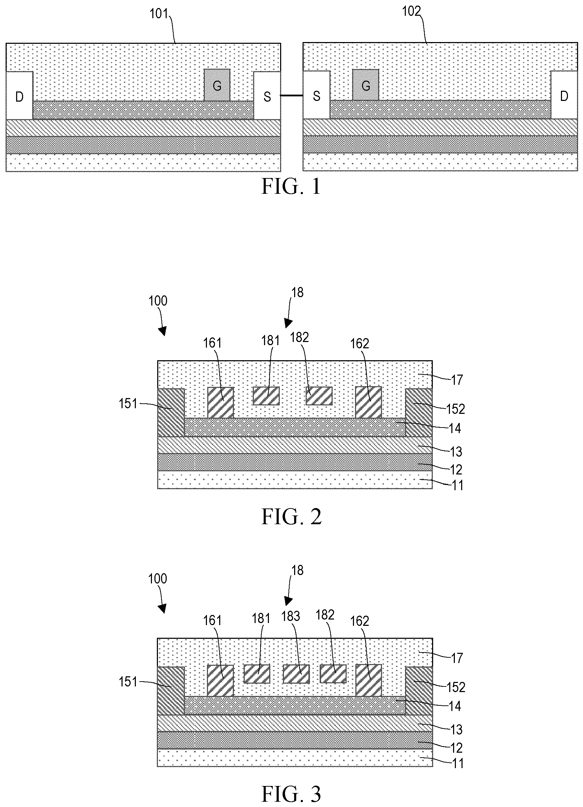

As described above, in the conventional solid-state circuit breaker, in order to achieve a bidirectional turn-off function, a conventional solution is to connect sources of a pair of power semiconductor devices to each other so as to be connected in series. Fig.1 shows a schematic structural view of a switch unit in a conventional solid-state circuit breaker. As shown in Fig.1, the switch unit includes a first HEMT device 101 and a second HEMT device 102. The source S of the first HEMT device 101 is connected to the source S of the second HEMT device 102, thereby connecting the first HEMT device 101 and the second HEMT device 102 in series. By controlling the voltages applied to the gates G of the two HEMT devices, bidirectional turn-off of the switch unit can be achieved. However, the use of two HEMT devices will increase an on-resistance and cost of the devices, and a corresponding heat dissipation difficulty will also be increased.

In addition, when a short circuit fault occurs, the current flowing through the solid-state circuit breaker gradually increases over time, and the device needs a certain time to be turned off, which results in the risk after the short circuit occurs being related to the time needed for the device to be turned off.

Embodiments of the present disclosure provide an architecture of a HEMT device and a method of fabricating the same. By providing two gates in the HEMT device and providing a floating field plate between the two gates, the HEMT device is enabled to achieve a bidirectional turn-off function, and is suitable for use in a solid-state circuit breaker. The HEMT device in the embodiments of the present disclosure can achieve bidirectional turn-off only by using a single die, without need of connecting sources of a pair of power semiconductor devices to each other so as to be connected in series, thereby significantly reducing an on-resistance and cost of the device. The principles of the present disclosure will be described below in connection with Figs. 2-6L.

Fig. 2 shows a schematic structural view of a HEMT device according to some embodiments of the present disclosure. As shown in Fig. 2, the HEMT device 100 described herein generally includes a substrate 11, a buffer layer 12, a channel layer 13, a barrier layer 14, a first electrode 151, a second electrode 152, a first gate 161, a second gate 162, a first floating field plate 181, and a second floating field plate 182.

In some embodiments, the substrate 11 may include any of silicon (Si), silicon carbide (SiC), or sapphire. The cost of a Si substrate is much lower than that of a SiC substrate or a sapphire substrate. It should be understood that, depending on design requirements, the substrate 11 can include any other suitable type of material, which is not limited by embodiments of the present disclosure.

As shown in Fig. 2, the buffer layer 12 is disposed on the substrate 11. In some embodiments, the buffer layer 12 may include gallium nitride (GaN) or aluminum gallium nitride (AlGaN). The buffer layer 12 may be doped or undoped. It should be understood that, depending on design requirements, the buffer layer 12 may include any other suitable type of material, which is not limited by embodiments of the present disclosure.

As shown in Figure 2, the channel layer 13 is disposed on the buffer layer 12. In some embodiments, the channel layer 13 may include a GaN epitaxial layer generated from undoped GaN. It should be understood that, depending on design requirements, the channel layer 13 may include any other suitable type of material, which is not limited by embodiments of the present disclosure.

As shown in Fig. 2, the barrier layer 14 is disposed on the channel layer 13. In some embodiments, the barrier layer 14 may include a nitrogen aluminum compound such as AlGaN or indium aluminum nitride (InAlN), such that the barrier layer 14 may form a heterojunction with the channel layer 13. It should be understood that, depending on design requirements, the barrier layer 14 can include any other suitable type of material, which is not limited by embodiments of the present disclosure.

As shown in Fig. 2, the first electrode 151 and the second electrode 152 are coupled to opposite sides of the barrier layer 14. In some embodiments, the first electrode 151 and the second electrode 152 may penetrate the barrier layer 14 and contact the channel layer 13, as shown in Fig. 2. However, it should be understood that the first electrode 151 and the second electrode 152 may not penetrate the barrier layer 14, which is not limited by embodiments of the present disclosure. In addition, the first electrode 151 and the second electrode 152 may include any suitable type of material, which is not limited by embodiments of the present disclosure.

As shown in Fig. 2, the first gate 161 is disposed on the barrier layer 14 adjacent to the first electrode 151 and is surrounded by the passivation layer 17, and the second gate 162 is disposed on the barrier layer 14 adjacent to the second electrode 152 and is surrounded by the passivation layer 17. By applying on-off control voltages to the first gate 161 and the second gate 162, an electric field distribution of a two-dimensional electron gas (2DEG) in the heterojunction can be controlled, thereby controlling a current flowing through the heterojunction. It should be understood that the first gate 161 and the second gate 162 may include any suitable type of material, which is not limited by embodiments of the present disclosure.

As shown in Fig. 2, the first floating field plate 181 and the second floating field plate 182 are disposed between the first gate 161 and the second gate 162 and spaced apart from the barrier layer 14. The first floating field plate 181 and the second floating field plate 182 may also be collectively referred to herein as floating field plates 18. The first floating field plate 181 is adjacent to the first gate 161, and the second floating field plate 182 is adjacent to the second gate 162. The first floating field plate 181 and the second floating field plate 182 are surrounded by the passivation layer 17. By providing the first floating field plate 181 and the second floating field plate 182 between the first gate 161 and the second gate 162, it is possible to optimize the electric field distribution of the two-dimensional electron gas (2DEG) in the heterojunction, thereby improving a breakdown voltage that the HEMT device 100 can tolerate when it is turned off in a case that a short circuit current or a rated current flows therethrough, and enhancing a device lifetime.

In some embodiments, a first turn-off voltage may be applied to the first gate 161 in a case that a short circuit current flows from the second electrode 152 to the first electrode 151. For example, a voltage of 0 V may be applied between the first gate 161 and the first electrode 151 as a first turn-off voltage. Similarly, a second turn-off voltage may be applied to the second gate 162, in a case that a short circuit current flows from the first electrode 151 to the second electrode 152. For example, a voltage of 0 V may be applied between the second gate 162 and the second electrode 152 as a second turn-off voltage.

It should be noted that the numbers, values, etc., mentioned above and elsewhere in the present disclosure are exemplary and are not intended to limit the scope of the present disclosure in any way. Any other suitable number or value is possible.

In some embodiments, in a case that a short circuit current flows from the second electrode 152 to the first electrode 151, the second gate 162 may remain floating. In some embodiments, in a case that a short circuit current flows from the first electrode 151 to the second electrode 152, the first gate 161 may remain floating.

In some embodiments, in order to further increase the breakdown voltage that the HEMT device 100 can tolerate when it is turned off, in a case that a short circuit current flows from the second electrode 152 to the first electrode 151, a corresponding adjusting voltage can be applied to at least one of the second gate 162, the first floating field plate 181 and the second floating field plate 182, and in a case that a short circuit current flows from the first electrode 151 to the second electrode 152, a corresponding adjusting voltage may be applied to at least one of the first gate 161, the first floating field plate 181 and the second floating field plate 182. Next, example control logic of the first gate 161, the second gate 162, the first floating field plate 181, and the second floating field plate 182 during device turn-off will be described.

In some embodiments, in a case that a short circuit current flows from the second electrode 152 to the first electrode 151, a corresponding adjusting voltage may be applied to each of the first floating field plate 181, the second floating field plate 182, and the second gate 162, and voltages of the second gate 162, the second floating field plate 182, the first floating field plate 181, and the first gate 161 are gradually decreased in a direction from the second electrode 152 to the first electrode 151. In this way, it is possible to make the voltage distribution more uniform in a portion of the two-dimensional electron gas (2DEG) located between the second electrode 152 and the first gate 161 in the heterojunction after the device is turned off, and ideally the voltage distribution within the portion of the two-dimensional electron gas is proportional to the distance to the first gate 161, thereby enabling the HEMT device 100 to tolerate a higher voltage in a shorter unit length for a longer time, significantly improving the service life of the device.

In some embodiments, in a case that a short circuit current flows from the second electrode 152 to the first electrode 151, voltages of the first gate 161, the first floating field plate 181, the second floating field plate 182, and the second gate 162 are sequentially applied in a direction from the first electrode 151 to the second electrode 152. As an example, a predetermined voltage may be applied between the first floating field plate 181 and the first electrode 151 as an adjusting voltage of the first floating field plate 181 after a short time (e.g., 1 microsecond or other time) after the first turn-off voltage is applied to the first gate 161. Subsequently, corresponding adjusting voltages can be applied sequentially to the second floating field plate 182 and the second gate 162.

It should be understood that in a case that a short circuit current flows from the second electrode 152 to the first electrode 151, after the first turn-off voltage is applied to the first gate 161, the adjusting voltages of the first floating field plate 181, the second floating field plate 182, and the second gate 162 may be applied in any other suitable order, which is not limited by embodiments of the present disclosure.

In some embodiments, the first electrode 151, the first gate 161, the first floating field plate 181, the second floating field plate 182, the second gate 162, and the second electrode 152 may be disposed at substantially equal intervals. In other embodiments, the intervals between two adjacent ones of the first electrode 151, the first gate 161, the first floating field plate 181, the second floating field plate 182, the second gate 162, and the second electrode 152 may be unequal.

In some embodiments, in a case that a short circuit current flows from the second electrode 152 to the first electrode 151, an adjusting voltage may be applied only to the first floating field plate 181, with the second floating field plate 182 and the second gate 162 remaining floating.

In some embodiments, in a case that a short circuit current flows from the first electrode 151 to the second electrode 152, a corresponding adjusting voltage may be applied to each of the first floating field plate 181, the second floating field plate 182, and the first gate 161, and voltages of the first gate 161, the first floating field plate 181, the second floating field plate 182, and the second gate 162 gradually decrease in a direction from the first electrode 151 to the second electrode 152. In this way, it is possible to make the voltage distribution more uniform in a portion of the two-dimensional electron gas (2DEG) located between the first electrode 151 and the second gate 162 in the heterojunction after the device is turned off, and ideally the voltage distribution within the portion of the two-dimensional electron gas is proportional to the distance to the second gate 162, thereby enabling the HEMT device 100 to tolerate a higher voltage in a shorter unit length for a longer time, significantly improving the service life of the device.

In some embodiments, in a case that a short circuit current flows from the first electrode 151 to the second electrode 152, the voltages of the second gate 162, the second floating field plate 182, the first floating field plate 181, and the first gate 161 are applied sequentially in a direction from the second electrode 152 to the first electrode 151. As an example, a predetermined voltage may be applied between the second floating field plate 182 and the second electrode 152 as an adjusting voltage of the second floating field plate 182 after a short time (e.g., 1 microsecond or other time) after the second turn-off voltage is applied to the second gate 162. Subsequently, corresponding adjusting voltages can be applied sequentially to the first floating field plate 181 and the first gate 161.

It should be understood that in a case that a short circuit current flows from the first electrode 151 to the second electrode 152, after the second turn-off voltage is applied to the second gate 162, the adjusting voltages of the first floating field plate 181, the second floating field plate 182, and the first gate 161 may be applied in any other suitable order, which is not limited by embodiments of the present disclosure.

In some embodiments, in a case that a short circuit current flows from the first electrode 151 to the second electrode 152, an adjusting voltage may be applied only to the second floating field plate 182, with the first floating field plate 181 and the first gate 161 remaining floating.

In some embodiments, when the HEMT device 100 is to be turned on and the voltage of the second electrode 152 is higher than the voltage of the first electrode 151, the first turn-on voltage may be applied to the first gate 161. For example, a voltage of 8 V may be applied between the first gate 161 and the first electrode 151 as the first turn-on voltage. Similarly, when the HEMT device 100 is to be turned on and the voltage of the first electrode 151 is higher than the voltage of the second electrode 152, the second turn-on voltage can be applied to the second gate 162. For example, a voltage of 8V may be applied between the second gate 162 and the second electrode 152 as the second turn-on voltage.

In some embodiments, in order to further reduce the on-resistance after the HEMT device 100 is turned on, when the HEMT device 100 is to be turned on and the voltage of the second electrode 152 is higher than the voltage of the first electrode 151, a corresponding adjusting voltage may be applied to at least one of the second gate 162, the first floating field plate 161, and the second floating field plate 182, and when the HEMT device 100 is to be turned on and the voltage of the first electrode 151 is higher than the voltage of the second electrode 152, a corresponding adjusting voltage may be applied to at least one of the first gate 161, the first floating field plate 161, and the second floating field plate 182. Next, example control logic of the first gate 161, the second gate 162, the first floating field plate 181, and the second floating field plate 182 during device turn-on will be described.

In some embodiments, when the HEMT device 100 is to be turned on and the voltage of the second electrode 152 is higher than the voltage of the first electrode 151, a corresponding adjusting voltage may be applied to each of the first floating field plate 181, the second floating field plate 182, and the second gate 162, and in a case that the HEMT device 100 is able to operate reliably, voltages of the second gate 162, the second floating field plate 182, and the first floating field plate 181 can be increased as much as possible, which contributes to a reduction in on-resistance of the device.

In some embodiments, when the HEMT device 100 is to be turned on and the voltage of the second electrode 152 is higher than the voltage of the first electrode 151, the voltages of the first gate 161, the first floating field plate 181, the second floating field plate 182, and the second gate 162 are applied sequentially in a direction from the first electrode 151 to the second electrode 152.

It should be understood that when the HEMT device 100 is to be turned on and the voltage of the second electrode 152 is higher than the voltage of the first electrode 151, after the first turn-on voltage is applied to the first gate 161, the adjusting voltages of the first floating field plate 181, the second floating field plate 182, and the second gate 162 can be applied in any other suitable order, which is not limited by embodiments of the present disclosure.

In some embodiments, when the HEMT device 100 is to be turned on and the voltage of the first electrode 151 is higher than the voltage of the second electrode 152, a corresponding adjusting voltage may be applied to each of the first floating field plate 181, the second floating field plate 182 and the first gate 161, and in a case that the HEMT device 100 is able to operate reliably, the voltages of the first gate 161, the first floating field plate 181, and the second floating field plate 182 can be increased as much as possible, which contributes to a reduction in on-resistance of the device.

In some embodiments, when the HEMT device 100 is to be turned on and the voltage of the first electrode 151 is higher than the voltage of the second electrode 152, voltages of the second gate 162, the second floating field plate 182, the first floating field plate 181, and the first gate 161 are applied sequentially in a direction from the second electrode 152 to the first electrode 151 .

It should be understood that when the HEMT device 100 is to be turned on and the voltage of the first electrode 151 is higher than the voltage of the second electrode 152, after the second turn-on voltage is applied to the second gate 162, the adjusting voltages of the first floating field plate 181, the second floating field plate 182 and the first gate 161 can be applied in any other suitable order, which is not limited by embodiments of the present disclosure.

In embodiments of the present disclosure, more or less floating field plate 18 may be provided between the first gate 161 and the second gate 162. As an example, a single floating field plate 18 may be provided between the first gate 161 and the second gate 162. As another example, in addition to the first floating field plate 181 and the second floating field plate 182, a third floating field plate 183 may be provided between the first gate 161 and the second gate 162, as shown in Fig. 3. The third floating field plate 183 may be disposed between the first floating field plate 181 and the second floating field plate 182. Further, four or more floating field plates 18 may be provided between the first gate 161 and the second gate 162. The control logic and example arrangements described above in connection with Fig. 2 for the first gate 161, the second gate 162, and the floating field plate 18 are equally applicable to the case that a single floating gate plate 18 or more than three floating field plates 18 are provided, which will be described briefly next.

In some embodiments, in a case that a short circuit current flows from the second electrode 152 to the first electrode 151, a corresponding adjusting voltage is applied to at least one of the one or more floating field plates 18 and the second gate 162, and in a case that a short circuit current flows from the first electrode 151 to the second electrode 152, a corresponding adjusting voltage is applied to at least one of the one or more floating field plates 18 and the first gate 161.

In some embodiments, in a case that a short circuit current flows from the second electrode 152 to the first electrode 151, a corresponding adjusting voltage is applied to each of the one or more floating field plates 18 and the second gate 162, and the voltages of the second gate 162, the one or more floating field plates 18, and the first gate 161 are gradually decreased in a direction from the second electrode 152 to the first electrode 151.

In some embodiments, in a case that a short circuit current flows from the first electrode 151 to the second electrode 152, a corresponding adjusting voltage is applied to each of the one or more floating field plates 18 and the first gate 161, and the voltages of the first gate 161, the one or more floating field plates 18, and the second gate 162 are gradually decreased in a direction from the first electrode 151 to the second electrode 152.

In some embodiments, in a case that a short circuit current flows from the second electrode 152 to the first electrode 151, the voltages of the first gate 161, the one or more floating field plates 18, and the second gate 162 are applied sequentially in a direction from the first electrode 151 to the second electrode 152.

In some embodiments, in a case that a short circuit current flows from the first electrode 151 to the second electrode 152, the voltages of the second gate 162, the one or more floating field plates 18, and the first gate 161 are applied sequentially in a direction from the second electrode 152 to the first electrode 151.

In some embodiments, when the HEMT device 100 is to be turned on and the voltage of the second electrode 152 is higher than the voltage of the first electrode 151, a first turn-on voltage is applied to the first gate 161, and when the HEMT device 100 is to be turned on and the voltage of the first electrode 151 is higher than the voltage of the second electrode 152, a second turn-on voltage is applied to the second gate 162.

In some embodiments, when the HEMT device 100 is to be turned on and the voltage of the second electrode 152 is higher than the voltage of the first electrode 151, a corresponding adjusting voltage is applied to at least one of the one or more floating field plates 18 and the second gate 162, and when the HEMT device 100 is to be turned on and the voltage of the first electrode 151 is higher than the voltage of the second electrode 152, a corresponding adjusting voltage is applied to at least one of the one or more floating field plates 18 and the first gate 161.

In some embodiments, when the HEMT device 100 is to be turned on and the voltage of the second electrode 152 is higher than the voltage of the first electrode 151, the voltages of the first gate 161, the one or more floating field plates 18, and the second gate 162 are applied sequentially in a direction from the first electrode 151 to the second electrode 152.

In some embodiments, when the HEMT device 100 is to be turned on and the voltage of the first electrode 151 is higher than the voltage of the second electrode 152, the voltages of the second gate 162, the one or more floating field plates 18, and the first gate 161 are applied sequentially in a direction from the second electrode 152 to the first electrode 151.

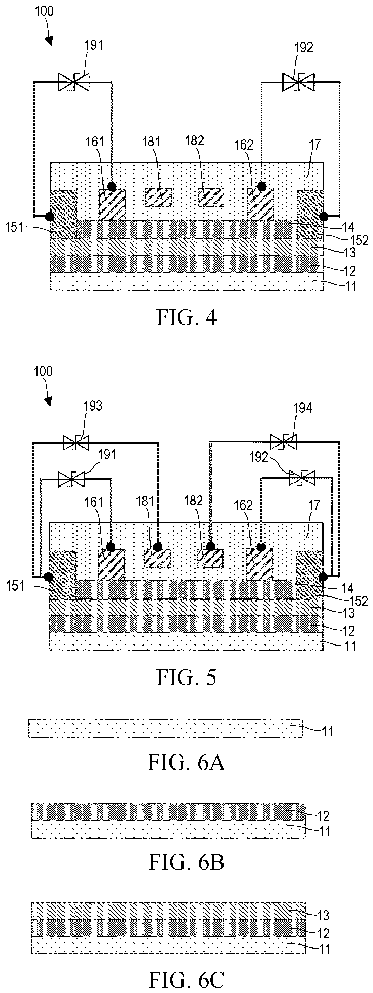

During turn-off of the HEMT device 100, transient voltage overshoots may occur at the floating gates in the first gate 161 and the second gate 162. In some embodiments, in order to avoid damage to the device by the transient voltage overshoots, the HEMT device 100 may also include a first voltage regulator diode 191 and a second voltage regulator diode 192, as shown in Figure 4. The first voltage regulator diode 191 is coupled between the first electrode 151 and the first gate 161. An anode of the first voltage regulator diode 191 is electrically connected to the first gate 161. A cathode of the first voltage regulator diode 191 is electrically connected to the first electrode 151. The second voltage regulator diode 192 is coupled between the second electrode 152 and the second gate 162. An anode of the second voltage regulator diode 192 is electrically connected to the second gate 162. A cathode of the second voltage regulator diode 192 is electrically connected to the second electrode 152.

In some embodiments, as shown in Figure 5, the HEMT device 100 may also include a third voltage regulator diode 193 and a fourth voltage regulator diode 194. The third voltage regulator diode 193 is coupled between the first electrode 151 and the first floating field plate 181. An anode of the third voltage regulator diode 193 is electrically connected to the first floating field plate 181. A cathode of the third Voltage regulator diode 193 is electrically connected to the first electrode 151. The fourth voltage regulator diode 194 is coupled between the second electrode 152 and the second floating field plate 182. An anode of the fourth voltage regulator diode 194 is electrically connected to the second floating field plate 182. A cathode of the fourth voltage regulator diode 194 is electrically connected to the second electrode 152.

The HEMT device 100 of embodiments of the present disclosure can be used in a solid-state circuit breaker, such as a direct current solid-state circuit breaker. In such a breaker, bidirectional turn-off can be achieved only by using a single die, without using a pair of power semiconductor devices, thereby significantly reducing cost of a solid-state circuit breaker.

Embodiments of the present disclosure also provide an example process of fabricating a HEMT device 100, as shown in Figs. 6A-6L.

As shown in Fig. 6A, a substrate 11 is provided. The substrate 11 may be of the type described in the embodiments described above in connection with Figs. 2-5 and will not be described again here.

As shown in Fig. 6B, a buffer layer 12 is formed on the substrate 11. The buffer layer 12 may be of the type described in the embodiments described above in connection with Figs. 2-5 and will not be described again here.

As shown in Fig. 6C, a channel layer 13 is formed on the buffer layer 12. The channel layer 13 may be of the type described in the embodiments described above in connection with Figs. 2-5 and will not be described again here.

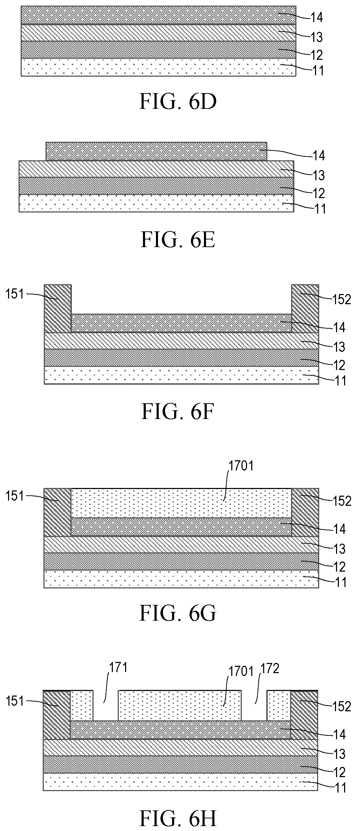

As shown in Fig. 6D, a barrier layer 14 is formed on the channel layer 13. The barrier layer 14 may be of the type described in the embodiments described above in connection with Figs. 2-5 and will not be described again here.

As shown in Fig. 6E, a portion of the barrier layer 14 is removed.

As shown in Fig. 6F, the first electrode 151 and the second electrodes 151 and 152 coupled to opposite sides of the barrier layer 14 are formed.

As shown in Fig. 6G, a first passivation layer 1701 is formed on the barrier layer 14.

As shown in Fig. 6H, the first passivation layer 1701 is etched to form a first through hole 171 and a second through hole 172 in the first passivation layer 1701. The first through hole 171 is adjacent to the first electrode 151, and the second through hole 172 is adjacent to the second electrode 152. Each of the first through hole 171 and the second through hole 172 extends from a first side of the first passivation layer 1701 facing away from the barrier layer 14 to a second side of the first passivation layer 1701 facing towards the barrier layer 14.

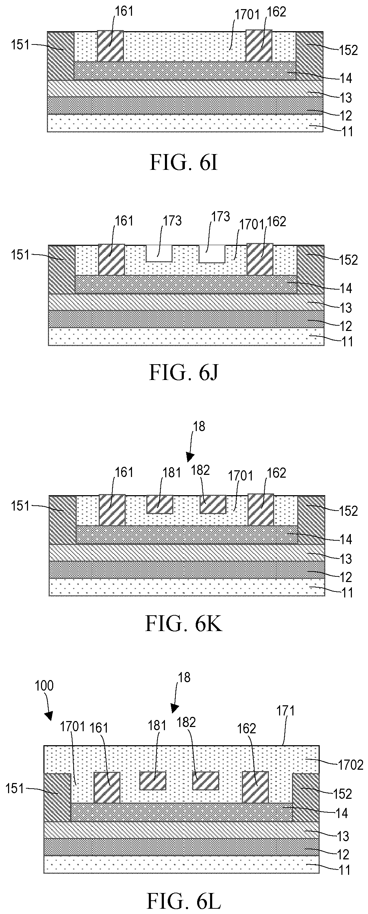

As shown in Fig. 6I, a conductive material is deposited in the first through hole 171 and the second through hole 172 to form a first gate 161 in the first through hole 171, and a second gate 162 in the second through hole 172.

As shown in Fig. 6J, the first passivation layer 1701 is etched to form one or more grooves 173 in the first passivation layer 1701, and the one or more grooves 173 extend from the first side of the first passivation layer 1701 to a predetermined depth within the first passivation layer 1701.

As shown in Fig. 6K, a conductive material is deposited in the one or more grooves 173 to form one or more floating field plates 18 in the one or more grooves 173.

As shown in Fig. 6L, a second passivation layer 1702 is formed on the first passivation layer 1701 to cover the first gate 161, the second gate 162, and the one or more floating field plates 18.

In some embodiments, the one or more floating field plates 18 include a first floating field plate 181 adjacent to the first gate 161 and a second floating field plate 182 adjacent to the second gate 162.

In some embodiments, the process of fabricating the HEMT device 100 further includes: forming a first voltage regulator diode 191 coupled between the first electrode 151 and the first gate 161; forming a second voltage regulator diode 192 coupled between the second electrode 152 and the second gate 162; forming a third voltage regulator diode 193 coupled between the first electrode 151 and the first floating field plate 181; and forming a fourth voltage regulator diode 194 coupled between the second electrode 152 and the second floating field plate 182.

Various embodiments of the present disclosure have been described above, which are exemplary, not exhaustive, and are not limited to the embodiments disclosed. Many modifications and variations will be apparent to those of ordinary skill in the art without departing from the scope and spirit of the illustrated embodiments. The selection of the terms used herein is intended to best explain the principles of the embodiments, practical applications, or technological improvements in the marketplace, or to enable others of ordinary skill in the art to understand the embodiments disclosed herein.

## Claims

1. A high electron mobility transistor (HEMT) device, comprising:
a substrate (11);
a buffer layer (12) disposed on the substrate (11);
a channel layer (13) disposed on the buffer layer (12);
a barrier layer (14) disposed on the channel layer (13);
a first electrode (151) and a second electrode (152) coupled to opposite sides of the barrier layer (14);
a first gate (161) and a second gate (162), wherein the first gate (161) is disposed on the barrier layer (14) adjacent to the first electrode (151) and surrounded by a passivation layer (17), and the second gate (162) is disposed on the barrier layer (14) adjacent to the second electrode (152) and surrounded by the passivation layer (17); and
one or more floating field plates (18) disposed between the first gate (161) and the second gate (162) and spaced apart from the barrier layer (14), the one or more floating field plates (18) being surrounded by the passivation layer (17).

2. The HEMT device according to claim 1, wherein a first turn-off voltage is applied to the first gate (161) in a case that a short circuit current flows from the second electrode (152) to the first electrode (151), and a second turn-off voltage is applied to the second gate (162) in a case that a short circuit current flows from the first electrode (151) to the second electrode (152).

3. The HEMT device according to claim 2, wherein in a case that a short circuit current flows from the second electrode (152) to the first electrode (151), a corresponding adjusting voltage is applied to at least one of the one or more floating field plates (18) and the second gate (162), and in a case that a short circuit current flows from the first electrode (151) to the second electrode (152), a corresponding adjusting voltage is applied to at least one of the one or more floating field plates (18) and the first gate (161).

4. The HEMT device according to claim 3, wherein in a case that a short circuit current flows from the second electrode (152) to the first electrode (151), a corresponding adjusting voltage is applied to each of the one or more floating field plates (18) and the second gate (162), and voltages of the second gate (162), the one or more floating field plates (18), and the first gate (161) are gradually decreased in a direction from the second electrode (152) to the first electrode (151); and
wherein in a case that a short circuit current flows from the first electrode (151) to the second electrode (152), a corresponding adjusting voltage is applied to each of the one or more floating field plates (18) and the first gate (161), and voltages of the first gate (161), the one or more floating field plates (18), and the second gate (162) are gradually decreased in a direction from the first electrode (151) to the second electrode (152).

5. The HEMT device according to claim 4, wherein in a case that a short circuit current flows from the second electrode (152) to the first electrode (151), voltages are sequentially applied to the first gate (161), the one or more floating field plates (18), and the second gate (162) in a direction from the first electrode (151) to the second electrode (152); and
wherein in a case that a short circuit current flows from the first electrode (151) to the second electrode (152), voltages are sequentially applied to the second gate (162), the one or more floating field plates (18), and the first gate (161) in a direction from the second electrode (152) to the first electrode (151).

6. The HEMT device according to claim 1, wherein when the HEMT device is to be turned on and a voltage of the second electrode (152) is higher than a voltage of the first electrode (151), a first turn-on voltage is applied to the first gate (161), and when the HEMT device is to be turned on and a voltage of the first electrode (151) is higher than a voltage of the second electrode (152), a second turn-on voltage is applied to the second gate (162).

7. The HEMT device according to claim 6, wherein when the HEMT device is to be turned on and the voltage of the second electrode (152) is higher than the voltage of the first electrode (151), a corresponding adjusting voltage is applied to at least one of the one or more floating field plates (18) and the second gate (162), and when the HEMT device is to be turned on and the voltage of the first electrode (151) is higher than the voltage of the second electrode (152), a corresponding adjusting voltage is applied to at least one of the one or more floating field plates (18) and the first gate (161).

8. The HEMT device according to claim 7, wherein when the HEMT device is to be turned on and the voltage of the second electrode (152) is higher than the voltage of the first electrode (151), voltages are sequentially applied to the first gate (161), the one or more floating field plates (18), and the second gate (162) in a direction from the first electrode (151) to the second electrode (152); and
wherein when the HEMT device is to be turned on and the voltage of the first electrode (151) is higher than the voltage of the second electrode (152), voltages are sequentially applied to the second gate (162), the one or more floating field plates (18), and the first gate (161) in a direction from the second electrode (152) to the first electrode (151).

9. The HEMT device according to any of claims 1 to 8, wherein the one or more floating field plates (18) comprise a first floating field plate (181) adjacent to the first gate (161) and a second floating field plate (182) adjacent to the second gate (162).

10. The HEMT device according to claim 9, wherein the first electrode (151), the first gate (161), the first floating field plate (181), the second floating field plate (182), the second gate (162), and the second electrode (152) are disposed at equal intervals.

11. The HEMT device according to claim 9, further comprising:
a first voltage regulator diode (191) coupled between the first electrode (151) and the first gate (161);
a second voltage regulator diode (192) coupled between the second electrode (152) and the second gate (162);
a third voltage regulator diode (193) coupled between the first electrode (151) and the first floating field plate (181); and
a fourth voltage regulator diode (194) coupled between the second electrode (152) and the second floating field plate (182).

12. A method of fabricating a high electron mobility transistor (HEMT) device, comprising:
providing a substrate (11);
forming a buffer layer (12) on the substrate (11);
forming a channel layer (13) on the buffer layer (12);
forming a barrier layer (14) on the channel layer (13);
forming a first electrode (151) and a second electrode (152) coupled to opposite sides of the barrier layer (14);
forming a first passivation layer (1701) on the barrier layer (14);
etching the first passivation layer (1701) to form a first through hole (171) and a second through hole (172) in the first passivation layer (1701), the first through hole (171) being adjacent to the first electrode (151), the second through hole (172) being adjacent to the second electrode (152), each of the first through hole (171) and the second through hole (172) extending from a first side of the first passivation layer (1701) facing away from the barrier layer (14) to a second side of the first passivation layer (1701) facing towards the barrier layer (14);
depositing a conductive material in the first through hole (171) and the second through hole (172) to form a first gate (161) in the first through hole (171), and to form a second gate (162) in the second through hole (172);
etching the first passivation layer (1701) to form one or more grooves (173) in the first passivation layer (1701), the one or more grooves (173) extending from the first side of the first passivation layer (1701) to a predetermined depth within the first passivation layer (1701);
depositing a conductive material in the one or more grooves (173) to form one or more floating field plates (18) in the one or more grooves (173); and
forming a second passivation layer (1702) on the first passivation layer (1701) to cover the first gate (161), the second gate (162), and the one or more floating field plates (18).

13. The method of claim 12, wherein the one or more floating field plates (18) comprise a first floating field plate (181) adjacent to the first gate (161) and a second floating field plate (182) adjacent to the second gate (162).

14. The method of claim 13, further comprising:
forming a first voltage regulator diode (191) coupled between the first electrode (151) and the first gate (161);
forming a second voltage regulator diode (192) coupled between the second electrode (152) and the second gate (162);
forming a third voltage regulator diode (193) coupled between the first electrode (151) and the first floating field plate (181); and
forming a fourth voltage regulator diode (194) coupled between the second electrode (152) and the second floating field plate (182).

15. A solid-state circuit breaker comprising the HEMT device according to any of claims 1 to 11.
